# EUROPEAN PATENT SPECIFICATION

(11) **EP 0 696 497 B1**
(45) Date of publication and mention of the grant of the patent: **18.11.1998**
(21) Application number: 95103418.0
(22) Date of filing: 09.03.1995
(51) Int. Cl.: B25J 7/00, B25J 15/02, B25J 9/12

(54) **Micro gripper**
Mikro-Greifer
Micro pince

(30) Priority: 12.08.1994 JP 190625/94; 15.11.1994 JP 280143/94; 13.01.1995 JP 21207/95
(43) Date of publication of application: 14.02.1996
(73) Proprietor: NIKON CORPORATION, Tokyo 100 (JP)
(72) Inventor: Suzuki, Yoshihiko, Funabashi-shi, Chiba-ken (JP)
(74) Representative: Lehn, Werner, Dipl.-Ing.

(56) References cited:
- EP-A- 0 198 501
- WO-A-89/10243
- US-A- 4 610 475
- US-A- 5 332 275
- PATENT ABSTRACTS OF JAPAN vol. 18 no. 9 (M-1538) ,10 January 1994 & JP-A-05 253870 (NIKON) 5 October 1993,
- PROCEEDINGS OF THE WORKSHOP ON MICRO ELECTRO MECHANICAL SYSTEMS INVESTIGATION OF MICRO STRUCTURES, SENSORS, ACTUATORS, MACHINES AND ROBOTS, NAPA VALLEY, FEB. 11 - 14, 1990, no. WORKSHOP 3, 11 February 1990 INSTITUTE OF ELECTRICAL AND ELECTRONICS ENGINEERS, pages 153-158, XP 000138638 FUKUDA TOSHIO ET AL 'MICRO ELECTRO STATIC ACTUATOR WITH THREE DEGREES OF FREEDOM'
- PATENT ABSTRACTS OF JAPAN vol. 00 no. 00 & JP-A-07 032276 (NIKON) 3 February 1995,
- JOURNAL OF MICROELECTROMECHANICAL SYSTEMS, vol. 1, no. 1, 1 March 1992 pages 31-36, XP 000304099 CHANG-JIN KIM ET AL 'SILICON-PROCESSED OVERHANGING MICROGRIPPER'
- REVIEW OF SCIENTIFIC INSTRUMENTS, vol. 55, no. 10, October 1984 NEW YORK US, pages 1669-1671, THIEL 'Simple,efficient uhv manipulator'

## Description

The present invention relates to a micro gripper that is intended to grip a micro object such as a micro mechanical component, an organism, etc.

The closest prior art JP-A-05 253870 describes a micro gripper device comprising a support member; two mutually opposed flexible fingers supported by said support member, said flexible fingers having gripping ends for gripping an object therebetween; and opening/closing drive means for gripping operation of said two fingers.

Another gripping device is described in WO 89/10243.

With progress in the semiconductor fabrication technology, it becomes possible to obtain small mechanical elements or small machines such as gears, electrostatic motors, micro pumps, etc., using the technology. The inventors disclosed a micro gripper capable of obtaining a great drive displacement with low-voltage drive using the semiconductor fabrication technology in Japanese Laid-open Patent Application No. 5-253870, and have been using it for fine work such as gripping, moving, assembling, cell fusion, etc. of protists or fine mechanical elements under a microscope. This micro gripper is so arranged that flexible plates each having a metal coil are provided as fingers, which are set under an external magnetic field, and an electric current is supplied through each finger coil to effect opening/closing of the flexible plates or fingers with a Lorentz force generated thereby. In actual work, the micro gripper is set at a distal end of a three-dimensional, hydraulically operated manipulator, a finger drive master input apparatus driven by a human finger (operator) is connected to a master input apparatus (joy stick) of the hydraulically operated manipulator, and the operator performs the operation while observing a gripped object and the two fingers of the micro gripper under the microscope or on a television monitor showing a microscopic image thereof.

The described technology represented a breakthrough and effective invention, but it was unable to be applied to cases where the object to be gripped by the micro gripper is a magnetic body, because the magnetic field needs to be applied to the flexible fingers.

An object of the invention is to provide a micro gripper having the feature that it can grip an object that should not be exposed to magnetic fields, such as a magnetic body, and a variety of other features.

According to the invention, there is provided a micro gripper device comprising a support member; two mutually opposed flexible fingers supported by said support member, said flexible fingers having gripping ends for gripping an object therebetween; and opening/closing drive means for gripping operation of said two fingers, characterized by a thermal mechanism provided on at least one of said gripping ends and for heating said object gripped by said gripping ends or measuring a temperature of said object gripped by said gripping ends; and an electrode provided on at least one of said two fingers and connected to said thermal mechanism, said electrode being provided for applying a voltage to said thermal mechanism or conducting current from said thermal mechanism.

The present invention will become more fully understood from the detailed description given hereinbelow and the accompanying drawings which are given by way of illustration only, and thus are not to be considered as limiting the present invention.

Further scope of applicability of the present invention will become apparent from the detailed description given hereinafter. However, it should be understood that the detailed description and specific examples, while indicating preferred embodiments of the invention, are given by way of illustration only, since various changes and modifications within the scope of the claims will become apparent to those skilled in the art from this detailed description, with reference to the drawings, in which:
Fig. 1 is a schematic, perspective view of a micro gripper according to a first explanatory embodiment referred to as Embodiment 1;
Fig. 2 is a drive device of a micro gripper according to a second explanatory embodiment, referred to as Embodiment 2;
Fig. 3 is a cross-sectional view of a micro gripper according to a third explanatory embodiment, referred to as Embodiment 3;
Fig. 4 is a schematic, perspective view to show the micro gripper according to Embodiment 3;
Fig. 5 and Fig. 6 are a schematic, perspective view and a schematic cross section to show a micro gripper according to a fourth explanatory embodiment, referred to as Embodiment 4;
Figs. 7A to 7E are drawings to show steps for producing the micro gripper according to Embodiment 4;
Fig. 8 is a schematic cross section to show a micro gripper according to a fifth explanatory embodiment referred to as Embodiment 5;
Figs. 9A to 9F are drawings to show steps for producing the micro gripper according to Embodiment 5;
Fig. 10 is a schematic, perspective view to show a micro gripper according to a first embodiment of the invention, referred to as Embodiment 6;
Figs. 11A to 11E are schematic cross sections to illustrate procedures for producing the micro gripper according to Embodiment 6;
Fig. 12 is a schematic plan view of a micro gripper according to a second embodiment of the invention, referred to as Embodiment 7;
Fig. 13 is a schematic cross section along B-B line in Fig. 12;
Figs. 14A to 14D are schematic cross sections to show an example of steps for producing the micro gripper shown in Figs. 12 and 13;
Figs. 15A to 15D are schematic cross sections to show steps for producing a finger body used for constructing a micro gripper according to a third embodiment of the invention, referred to as Embodiment 8;
Figs. 16A to 16D are schematic cross sections to show steps for producing a finger body used for constructing a micro gripper according to a fourth embodiment of the invention, referred to as Embodiment 9;
Fig. 17 is a schematic plan view of a finger body used for constructing a micro gripper according to a fifth embodiment of the invention, referred to as Embodiment 10;
Fig. 18 is a schematic cross section along C-C line in Fig. 17;
Figs. 19A and 19B are schematic cross sections to show an example of steps for producing the finger body shown in Figs. 17 and 18;
Fig. 20 is a schematic plan view of a finger body used for constructing a micro gripper according to a sixth embodiment of the invention, referred to as Embodiment 11;
Fig. 21 is a schematic cross section along D-D line in Fig. 20; and
Figs. 22A to 22C are schematic cross sections to show an example of steps for producing the finger body shown in Figs. 20 and 21.

Various explanatory embodiments and embodiments of the present invention will be described with reference to the accompanying drawings.

A plurality of projections or depressions (a holding portion for capture) are provided at distal ends of two fingers, whereby the gripped object (fine body) gripped thereby becomes unlikely to slip.

The capacitance is detected between a pair of metal plates provided in the two respective fingers of the micro grip, whereby a space between the two fingers or a state of the gripped object (fine body) relative to the fingers (gripped state) can be detected. This is because the capacitance between the metal plates is proportional to an area of the metal plates and a dielectric constant of a medium in which the micro gripper is placed (a medium between the metal plates), but inversely proportional to the distance d between the metal plates, i.e., the space between the two fingers.

Further, drive signals of the fingers can be changed according to the capacitance (signal) changing depending upon an open/close state of the fingers.

For example, as the capacitance (signal) becomes larger (namely, as the two fingers approach each other), an amplification factor of the drive signals can be set smaller. This can prevent an excessively large drive signal from being supplied to the micro gripper, even if a man (operator) excessively gives a close signal (a signal to close the two fingers). Therefore, the two fingers can be prevented from colliding with each other hard and from gripping the gripped object (fine body) with a too strong force.

Also, depending upon the magnitude of the capacitance (signal), voice (for example, buzzer sound etc.) can be generated as changing the frequency, the amplitude, or both the frequency and the amplitude. By this arrangement, the gripping work can be done while listening to the sound depending upon the open/close state of the fingers of the micro gripper, which can realize the work with realism and which permits the operator to judge whether or not the gripper accurately grips the gripped object (fine body).

Further, depending upon the magnitude of the capacitance (signal), a reactive force can be produced in the opening/closing input apparatus operated by the man (operator). This opening/closing input apparatus is for opening and closing the fingers. The reactive force can be generated by changing the frictional resistance against an open/close action of the opening/closing input apparatus, using a reactive force generator such as an electromagnetic brake or a wire brake, etc. For example, as the fingers grip the gripped object (fine body) with a stronger force, a greater reaction force can be generated in the opening/closing input apparatus operated by the man (operator). This permits the man to feel as if the man is directly gripping the gripped body of micron order, which enables the work full of realism, which has never been realized heretofore, and which permits the operator to judge whether or not the gripped object (fine body) is accurately gripped.

If the fingers are flexible fingers, the metal plates may be replaced by resistors and the resistance thereof changing depending upon deflection of the flexible fingers can be detected, achieving the same effect as in the case of using the capacitance.

### Embodiment 1

The fingers of the micro gripper shown in Japanese Laid-open Patent Application No. 5-253870 as described previously are two flexible fingers each being a flexible plate provided with a metal coil. When the two flexible fingers are placed under an external magnetic field and when an electric current is let to flow through the metal coils in the flexible fingers, the flexible fingers are subject to the Lorentz force to be deflected. The two flexible fingers are opened and closed by this deflection to grip a fine body etc. (gripped object).

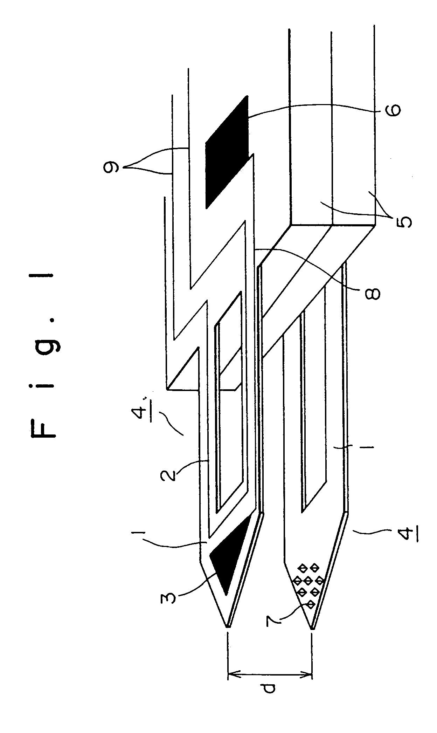

Fig. 1 is a schematic, perspective view of the micro gripper according to Embodiment 1.

A metal coil 2 and a metal plate 3 are provided on a flexible plate 1 projecting from a support member 5, so that a flexible finger 4 is composed of the flexible plate 1, metal coil 2, and metal plate 3. The metal coil 2 is provided for opening and closing the flexible finger 4 (as opening/closing means), but if another type of opening/closing means is used, this metal coil 2 can be omitted.

The metal coil 2 is formed along the periphery of the flexible plate 1. Also, the metal coil 2 is electrically connected to drive signal electrodes not shown through drive signal lines 9.

The metal plate 3 is connected to a capacitance detecting electrode 6 through a capacitance detection signal line 8.

The metal coil 2, metal plate 3, capacitance detecting electrode 6, capacitance detection signal line 8, and drive signal lines 9 are formed on each of the both outside surfaces of the micro gripper. The drive signal electrodes (not shown) and capacitance detecting electrode 6 are connected to an external drive power supply and a capacitance sensor, using metal wires.

A plurality of projections 7 (holding portion for capture) are formed at the distal end of the flexible plate 1 so as not to be slippery when the gripped object (fine body) is gripped. This plurality of projections 7 (holding portion for capture) can be formed in a shape matching with the gripped object (fine body). The plurality of projections 7 (holding portion for capture) may be omitted.

In the next place, a method for producing the micro gripper is described.

In this embodiment, the flexible plate 1 is formed of a silicon nitride film and the support member 5 of silicon.

The silicon nitride film is formed in the thickness of 250 nm from raw materials of dichlorosilane and ammonium gas by the low pressure vapor phase growth method on an n-type silicon substrate of the diameter of 7.6 cm (3 inches) the thickness of 250 µm, and the (100) orientation.

Next, the silicon nitride film on the substrate is partially removed by the photolithography process and dry etching process in order to form the capture holding portion in the flexible finger 4. Five to fifteen projections are intended to be produced at the distal end of finger each in a shape about 5 µm to about 10 µm square after removal. The shape, size, and number of these projections can be arbitrarily determined so as to match with an object to be gripped. After that, this substrate is immersed in an etchant of silicon, such as a potassium hydroxide (hereinafter referred to as KOH) solution or a tetramethyl ammonium hydroxide (hereinafter referred to as TMAH) solution, to etch exposed silicon portions in a quadrangular pyramid shape, thereby forming a plurality of recesses. Then a silicon nitride film is again formed in the thickness of 250 nm over the entire surface of substrate by the low pressure vapor phase growth method. The silicon nitride film has projections corresponding to the portions of recesses of silicon. In this manner, the capture holding portion (projections 7) is formed in a convex shape on the flexible plate 1. Using the same method, the capture holding portion may also be formed in a concave shape.

This substrate is subjected to the dry etching process with a resist film as a protective layer so as to remove unnecessary portions of the silicon nitride film, thus forming the flexible finger 4 in a hollow shape in length of 600 µm and in width of 120 µm. In this case, the shape of the flexible finger 4 does not have to be the hollow shape, but can be any arbitrary shape.

Next, metal patterns are formed in portions corresponding to the metal plate 3, coil 2, drive signal line 4, capacitance detection signal line 8, capacitance detection electrode 6, and unrepresented drive signal electrodes.

First, a resist film is formed in the thickness of 1 µm by the photolithography process and patterning is carried out in shapes of metal plate 3, coil 2, drive signal line 4, capacitance detection signal line 8, capacitance detection electrode 6, and unrepresented drive signal electrodes. After that, a film of NiCr is formed in 1 nm using the vacuum vapor deposition process, and then Au is formed in 49 nm over the entire surface. Here, the reason why the two-layer films are formed is that, because Au has weak adhesion to silicon nitride, the NiCr film having strong adhesion to silicon nitride is first formed. Although Embodiment 1 used the two-layer films, a single-layer film is also applicable. Further, the device is not limited to the films used in Embodiment 1. The films used herein are preferably those of materials having strong adhesion to the material (silicon nitride) of flexible plate 1, small electric resistance, and high alkali resistance. This is because a film with weak adhesion is likely to be peeled off, because a film with large electric resistance reduces electric current flow, and because a film with low alkali resistance will also be etched together with the material (silicon) of support member 5 upon etching thereof. Next, this sample is immersed in acetone in an ultrasonic cleaner to remove unnecessary resist portions and metal film portions, thus obtaining the necessary metal patterns.

The silicon nitride film in the back surface portion of the substrate after the above treatments is etched to be removed partially (in the portion where the flexible finger 4 is to be formed); the whole sample is then immersed in a silicon etchant such as KOH, TMAH, etc. to dissolve silicon partially (in the portion where the flexible finger 4 is to be formed), thus obtaining a structure having one flexible finger with the support member 5 of silicon.

Two such structures are prepared and bonded to each other by an adhesive or by the anode coupling method between surfaces not having the metal patterns etc., of the two structures, thereby producing the micro gripper provided with the metal plate 3 at the distal end of each finger as shown in Fig. 1.

The micro gripper can be obtained by forming finger portions, tips, coils and metal plates on both sides of a single substrate, then removing unnecessary part of the substrate by the etching process.

Embodiment 1 used silicon nitride as the material for flexible plate 1, but other materials may be used. For example, polyimide may be used to form the film on the silicon substrate by the spin coat method, as the flexible plate, thus obtaining a similar micro gripper.

Also, the substrate is not limited to the n-type silicon, but may be p-type silicon or any other material than silicon.

Since the metal plate 3 is formed in each of the two flexible fingers 4 in the manner as described, a capacitance can be detected between the metal plates 3, depending upon the state of flexible fingers 4. If a resistor is provided instead of the metal plate 3, a resistance change depending upon deflection of flexible finger 4 (a state of flexible finger 4) can be detected.

### Embodiment 2

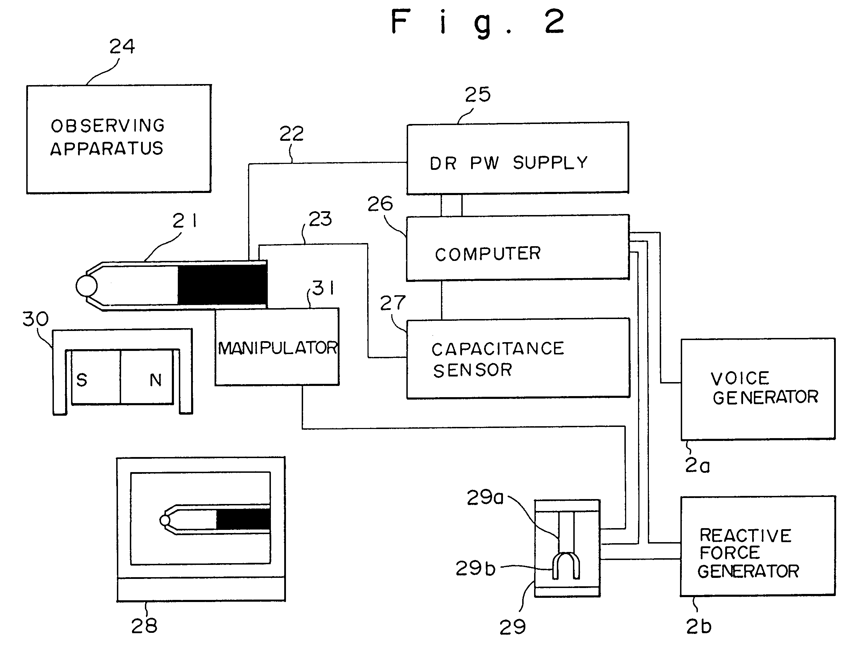

Fig. 2 shows a drive apparatus for micro gripper according to Embodiment 2.

The micro gripper used in Embodiment 1 is used under the system construction shown in Fig. 2.

Namely, the micro gripper 21 is installed below an observing apparatus 24 consisting of a microscope provided with a CCD camera, and a microscopic image picked up by the CCD camera is arranged to be observed on a television monitor 28.

A magnetic field is applied to the micro gripper 21 by magnetic field generating means 30. This magnetic field generating means 30 is a means that can generate a magnetic field, such as a permanent magnet or an electric magnet.

Opening/closing of the flexible fingers is effected using the magnetic field generating means 30 and coils 2 (opening/closing means).

The micro gripper 21 is set on a hydraulic manipulator 31 (moving means) so as to be three-dimensionally movable.

Positional movement of the micro gripper 21 and opening/closing of the fingers in the micro gripper 21 is carried out using a master input device 29 consisting of a joy stick 29a for driving the three-dimensional, hydraulic manipulator on which the micro gripper 21 is set, and an opening/closing input device 29b integrally formed with the joy stick 29a.

The opening/closing of the two fingers in the micro gripper is made when a human operator manipulates the opening/closing input device 29b in the master input device 29. With this opening/closing operation, an electric signal is generated depending upon the opening/closing operation by a displacement-voltage transforming device such as an encoder or a differential transformer as set in the opening/closing input device 29b. This electric signal is put into a computer 26, and this computer 26 executes signal processing such as multiplication by an arbitrary amplification factor. This signal-processed electric signal is used to control a signal amplitude of a drive signal 22 generated from a drive power supply 25, and the opening/closing of the flexible fingers in the micro gripper 21 is controlled using this drive signal 22.

In such a drive apparatus for micro gripper, a capacitance sensor 27 detects a capacitance signal 23 change depending upon the opening/closing state of the flexible fingers or a state between the flexible fingers and the gripped object (fine body) (which is a gripped state), etc., and the detected signal can be entered into the computer 26. Then, the computer can perform such an adjustment that the amplification factor of drive signal 22 is decreased in the computer as the capacitance signal 23 becomes greater, that is, as the two fingers approach each other. According to this adjustment, even if the opening/closing input device 29b in the master input device 29 generates an excessive close signal (a signal to close the flexible fingers), the drive signal 22 generated from the drive power supply 25 can be adjusted into a signal of a moderate amplitude, thereby preventing occurrence of a problem that the gripped object (fine body) is gripped with an excessive force.

Further, the computer 26 generates a voice signal modified in frequency or amplitude or both in frequency and amplitude depending upon the magnitude of capacitance signal 23 to make a voice generating apparatus 2a generate a voice, whereby the operator can perform the gripping work while listening to the voice depending upon the opening/closing state of the fingers in the micro gripper, thus realizing the work with realism, and whereby the operator can judge whether or not the gripped object (fine body) is accurately gripped.

Further, the magnitude of frictional resistance or reactive force against the opening/closing motion of the opening/closing input device 29b is changed depending upon the magnitude of capacitance signal 23, whereby a greater reactive force can be generated in the opening/closing input device operated by the man (operator) as the gripped object is gripped with a stronger force. This reactive force is changed using a reactive force generating apparatus such as an electromagnetic brake or wire brake not shown. This arrangement makes the operator feel as if he is directly gripping the gripped object (fine body) of micron order, thus enabling the work with realism, which has never been achieved heretofore and enabling the operator to judge whether or not the gripped object (fine body) is accurately gripped.

The same operation is possible, similarly as in Embodiment 1, by such an arrangement that a resistor replaces the metal plate, 3 to detect a resistance changing depending upon deflection of flexible finger 4, thus using the resistance instead of the capacitance.

Although Embodiment 2 is so arranged that the operator can sense the gripped state applying the state of flexible fingers (gripped state) to the sound or the reactive force of opening/closing input device 29b, the present disclosure is by no means limited to this arrangement but may employ any means for detecting it. For example, a value according to the capacitance or resistance may be displayed on a screen.

### Embodiment 3

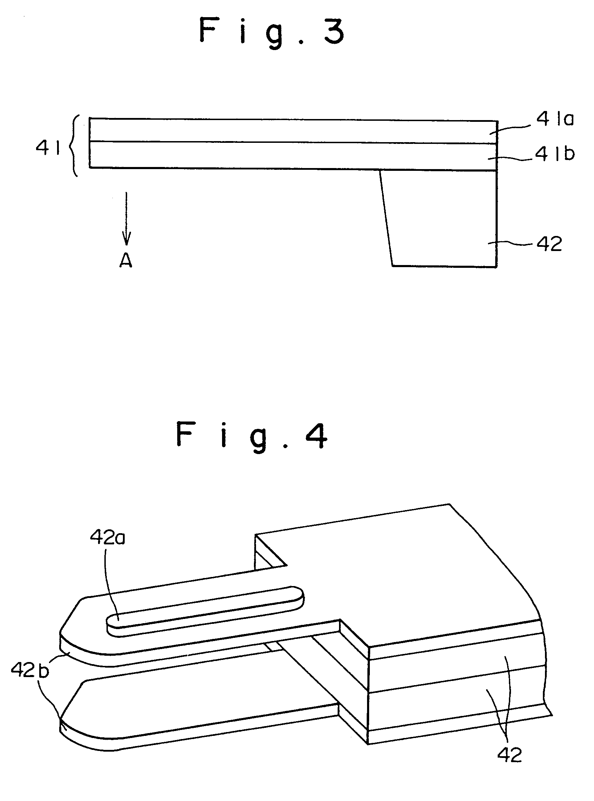

Embodiment 3 is next described referring to Fig. 3, which is a cross section of a micro gripper.

The micro gripper is prepared in such a manner that two structures each consisting of a support member 42 and a flexible finger 41 made of a flexible thin film 41b and a flexible thin film 41a are produced and that the two support members 42 are bonded to each other by the anode coupling method or by an adhesive. In this arrangement, the flexible thin film 41b projects from the support member 42, and the flexible thin films 41a, 41b have mutually different thermal expansion coefficients. When heat is generated in the flexible finger 41 with energy irradiation such as light from the outside onto the flexible finger 41, the flexible finger 41 is distorted because of a difference in thermal expansion between the thin films 41a, 41b forming the flexible finger 41, thus achieving the gripping operation.

In this case, if the two opposed flexible fingers 41 are intended to approach each other or to be distorted in the direction A in Fig. 3, the flexible thin film 41b on the support member side should be made of a material with smaller thermal expansion coefficient than that of the flexible thin film 41a.

Fig. 4 is a schematic, perspective view to show the micro gripper according to Embodiment 3 of the present invention.

Embodiment 3 of the present invention is next described in detail referring to Fig. 4.

First, the micro gripper is prepared utilizing the semiconductor fabrication technology. Production procedures of the micro gripper are detailed in the following. A silicon nitride film 42b is formed in the thickness of 500 nm on an n-type silicon substrate of the diameter of 3 inches, the thickness of 250 µm, and the (100) orientation from raw materials of dichlorosilane and ammonium gas by the low pressure vapor phase growth method. After that, patterning is done to form an aluminum thin film 42a in the thickness of 200 nm over the top surface of this substrate by the lift-off process. Silicon nitride is a material having a smaller thermal expansion coefficient than that of aluminum. It should be noted that the thin film materials forming the flexible finger do not always have to be shaped in a same shape in the two layers.

Next, this substrate is subjected to the dry etching process with a resist film as a protective layer to remove unnecessary portions of the silicon nitride layer, thereby forming a finger shaped as shown in Fig. 4 in length of 200 µm to 1 mm and in width of 40 µm to 200 µm. In this case, the finger shape is not limited to that shown in Fig. 4, but may be an arbitrary shape. The silicon nitride layer in the back face portion of the thus treated sample is partially etched to be removed and the entire sample is then immersed in a silicon etchant such as KOH, TMAH, etc. to partially dissolve silicon, thus achieving a structure having one finger with the support member 42 of silicon. Two such structures are prepared and surfaces of silicon nitride films thereof without pattern are bonded to each other by an adhesive or by the anode coupling process, thereby obtaining the micro gripper provided with the flexible fingers as shown in Fig.4.

While holding the thus obtained micro gripper in water, laser pulse light of wavelength 633 nm was irradiated onto the flexible finger portions to actuate them. On this occasion, an amount of opening/closing of the flexible fingers was controlled by changing time intervals between irradiation pulses in the irradiated laser light. Namely, the laser light with shorter pulse intervals was irradiated to distort the flexible fingers more.

Although Embodiment 3 used silicon nitride and aluminum as the materials with different thermal expansion coefficients, they may be replaced by any other materials. However, if the flexible fingers are intended to move in closing directions, the material on the side where the two flexible fingers are opposed to each other should have a smaller thermal expansion coefficient. The thin films forming the flexible finger do not always have to be of two layers, but they may be multilayers of thin films.

Although Embodiment 3 used irradiation with laser pulses to apply the heat to the flexible finger portions, a heating device may be any means that can apply the heat such as Joule heat to the flexible finger portions.

The description was omitted about the apparatus for driving the micro gripper in Embodiment 3, because it is the same as the previously described one. Namely, the micro gripper is mounted on the hydraulic manipulator and the position of the micro gripper can be moved in X, Y, Z directions by the hydraulic manipulator. A joy stick may be provided in order to send a signal for moving the micro gripper, to the hydraulic manipulator. The opening/closing of the flexible fingers may be driven by controlling the quantity of heat (for example, by changing the time intervals of the laser pulses) applied to the flexible fingers by the heating device (for example, the apparatus for generating the laser pulses) in accordance with a signal from the opening/closing device for opening/closing the flexible fingers.

### Embodiment 4

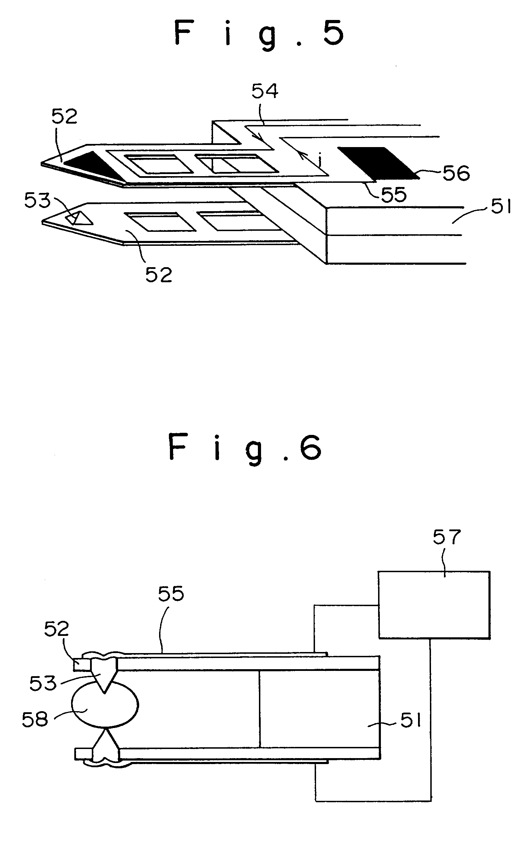

Fig. 5 is a schematic perspective view to show a micro gripper according to Embodiment 4 and Fig. 6 illustrates a schematic cross section thereof.

The micro gripper according to Embodiment 4 is provided with a support member 51, two flexible fingers 52, probes 53 formed at distal ends of the two flexible fingers 52 and entirely made of a metal (conductor), micro coils 54 provided in the two respective flexible fingers 52, metal wires 55 connected to the corresponding probes 53, band electrode layers 56 electrically connected to the respective metal wires 55. The two electrode layers 56 provided on the top surface and on the bottom surface of the support member 51 are electrically connected to a measurement device 57 for measuring an electric property of the gripped object (Fig. 6). A power supply (not shown) is connected to the two micro coils 54 in order to supply an electric current to the micro coils 54.

The method for gripping the gripped object with the micro gripper may be one disclosed in Japanese Laid-open Patent Application No. 5-253870 as described previously, in which a magnetic field is applied in parallel with the longitudinal direction of the flexible fingers 52 and the electric current flowing through the micro coils 54 is controlled in magnitude and direction.

In order to measure the electric property of the gripped object 58, the measurement device 57 measures the electric property such as the resistance, after the gripped object 58 is gripped by the above method, as shown in Fig. 6.

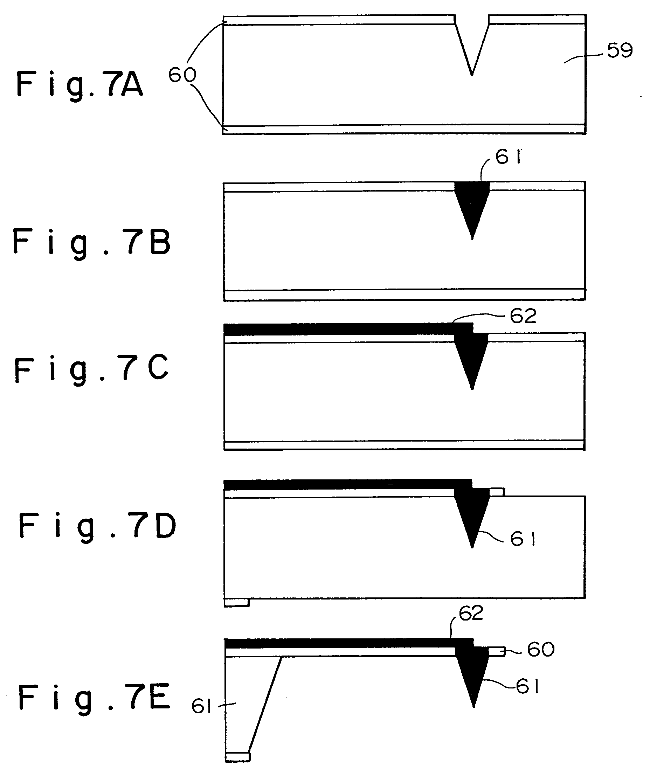

The process for producing the micro gripper of Fig. 5 is next described referring to Fig. 7A to Fig. 7E. First, a single crystal silicon substrate 59 of the (100) orientation is prepared. Then dichlorosilane (SiH₂Cl₂) and ammonium gas (NH₃) are introduced as raw material gases into a CVD apparatus, and a silicon nitride (SiN_{X}) film 60 is formed in the thickness of 0.1 to 2.0 µm on the both surfaces of substrate 59 by the vapor phase growth method. In Embodiment 4 this silicon nitride film 60 becomes the flexible finger 52 in Figs. 5 and 6. An insulator material containing silicon (for example, SiO_{X} or SiO_{X}N_{Y}, etc.) may be used instead of silicon nitride. After that, part of the silicon nitride film 60 is removed in a substantially square shape by the dry etching process using a gas such as CF₄, SF₆, etc., thereby forming an exposed portion where the surface of silicon substrate 59 is exposed. Further, anisotropic etching is performed using the KOH solution etc. with the silicon nitride film 60 as a mask, thus forming a recess of a quadrangular pyramid shape in the silicon substrate 59 (Fig. 7A).

Next, tungsten hexafluoride (WF₆) gas is introduced as a raw material gas into the CVD apparatus and tungsten (W) 61 is let to be deposited only in the portion where silicon of substrate 59 is exposed (the recess portion) by the selective CVD process utilizing a reduction reaction of silicon (Fig. 7B). In Embodiment 4 this quadrangular pyramid tungsten 61 becomes the probe 53 in Figs. 5 and 6. The probe 53 is formed about 5 µm square and about 3.5 µm high. Only one probe 53 is formed in Embodiment 4, but the shape, size, and number of the probe 53 can be arbitrarily determined in accordance with the object to be gripped.

Further, a photoresist is applied onto the silicon nitride film 60 and patterning is performed in the predetermined wiring shape. Then, an aluminum thin film is formed over the resist and thereafter the resist is removed (by the so-called lift-off method) to form wiring 62 of the aluminum thin film in the thickness of 200 nm (Fig. 7C). This wiring 62 constitutes the micro coil 54, line 55, and electrode layer 56 shown in Fig. 5 at a time.

After that, unnecessary portions of the silicon nitride film 60 are removed by dry etching using a gas such as CF₄, SF₆ etc. in accordance with the desired shape (Fig. 5) of the flexible plate 52 (Fig. 7D).

Then the exposed silicon portions are dissolved in the KOH solution etc., thereby producing one structure having the flexible finger 53 (Fig. 7E).

Two such structures are produced and are bonded to each other by an adhesive or by the anode coupling method between surfaces thereof not having the metal patterns etc. (surfaces of support members 51). The micro gripper shown in Figs. 5 and 6 is thus produced in this manner.

The thus obtained micro gripper was used to grip a protozoa such as vorticella in contact with the probes 53 and resistance measurement was carried out. It was confirmed that the resistance of vorticella was able to be measured. It is needless to mention that a variety of electric measurements of the gripped object can be done, including not only the resistance measurement but also capacitance measurement between the probes 53, etc.

### Embodiment 5

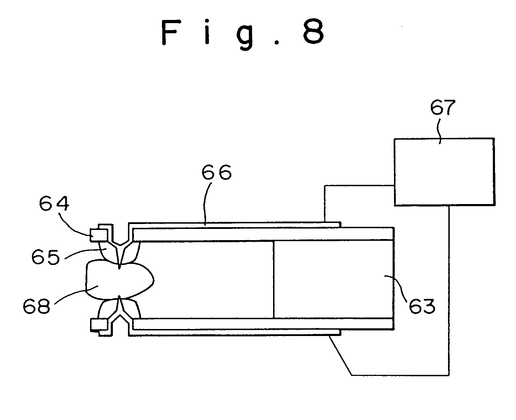

Fig. 8 is a schematic cross section to show a micro gripper according to Embodiment 5, which is substantially the same as Embodiment 4 except that the shape of probes is different from that in Embodiment 4. Since the opening/closing operation of the flexible fingers can be carried out in the same manner as in Embodiment 4, the same description as in Embodiment 4 will be omitted.

In Embodiment 5, the shape of probes 65 is so defined that a conductor (metal) projects out only at the distal end but the other part is covered with an insulator.

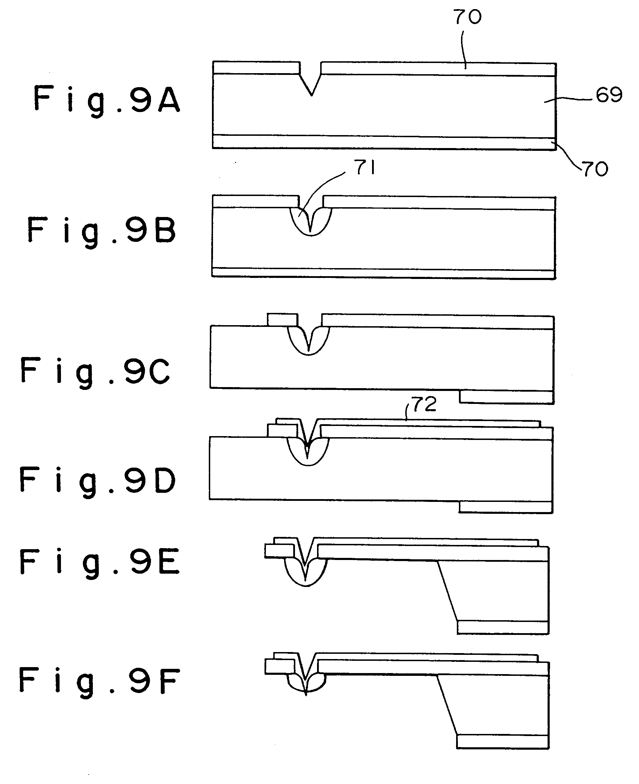

The method for producing the micro gripper according to Embodiment 5 is next described referring to Figs. 9A to 9F.

A silicon nitride film 70 is formed in the thickness of 700 nm on an n-type silicon substrate 69 of the diameter of 7.6 cm (3 inches), the thickness of 250 µm, and the (100) orientation from raw materials of dichlorosilane and ammonium gas by the low pressure vapor phase growth method. Further, the silicon nitride film 70 on the substrate 69 is partially removed by the photolithography process and dry etching process. The shape of the removed part is a square with each side of about 5 µm to about 10 µm. The pattern shape, size, and number of it can be arbitrarily set to match with the gripped object. After that, this substrate 69 is immersed in a silicon etchant such as the KOH solution or the TMAH solution, and an exposed silicon portion is etched in a quadrangular pyramid shape to form a recess (Fig. 9A).

After that, the substrate 69 is set in an electric oven and a silicon dioxide film 71 is let to grow in the exposed silicon recess (Fig. 9B). As well known, a growth speed of silicon dioxide film 71 is fast in a flat portion but slow in a corner portion. Thus, a cross section of the silicon dioxide film grown in the recess becomes as shown in Fig. 9B, so that the bottom portion is thin.

After that, the surface of the silicon nitride film 70 formed on the top surface side of substrate is patterned in the shape of the flexible finger and the surface of silicon nitride film 70 formed on the back surface side of substrate is patterned in the shape of the support member. Further, patterning of a metal film 72 of gold, platinum, NiCr, Ti, Cr etc. is performed by the lift-off method on the top surface side of substrate, thereby forming a micro coil for drive and a metal line 72 at a time (Fig. 9D).

After that, the sample is immersed in TMAH to dissolve only unnecessary silicon portions, thereby forming a structure having a flexible finger in a cantilever state (Fig. 9E).

This sample is then immersed in the KOH solution to etch a little part of the silicon dioxide film in the probe portion, thus forming a probe where the metal is exposed from the tip end of the silicon dioxide film 71 (Fig. 9F).

Two such structures are produced and bonded to each other by an adhesive or by the anode coupling method between surfaces thereof not having the metal lines etc. In this manner, the micro gripper is able to be produced with a probe having an exposed metal from the tip end of silicon dioxide layer 71.

In the previously described Embodiment 4, the entire probe 53 is of a conductor and then, if the gripped object is soft, the depth of penetration, as defined as a depth in which the probe 53 penetrates into the gripped object, cannot be constant. Thus, because the contact area cannot be constant between the gripped object and the metal probe 53, there are cases that the electric property of a same gripped object cannot be detected on a stable basis. Accordingly, for soft gripped objects, the electric property thereof can be detected on a stable basis using the micro gripper with the probe having the conductor only at the top portion as in Embodiment 5, because the contact area is constant between the conductor portion and the gripped object.

The thus obtained micro gripper according to Embodiment 5 was used to grip a protozoa such as vorticella in contact with the probe portions and resistance measurement was repeated. It was confirmed that variations of measurement were able to be reduced half.

In Embodiments 4 and 5 the opening/closing drive means for opening and closing the flexible fingers was constructed of the micro coils and an electric current through the micro coils was controlled. The other means can be employed therefor, of course. One of such means is arranged for example in such a manner that two metal layers with different thermal expansion coefficients are provided on an outer surface or an inner surface of flexible finger (as called as a bimetal or bimorph structure) and the heat applied to the two metal layers is controlled.

### Embodiment 6

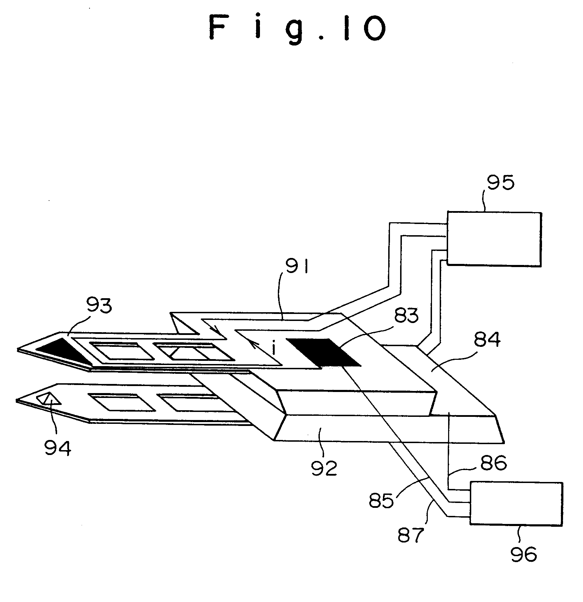

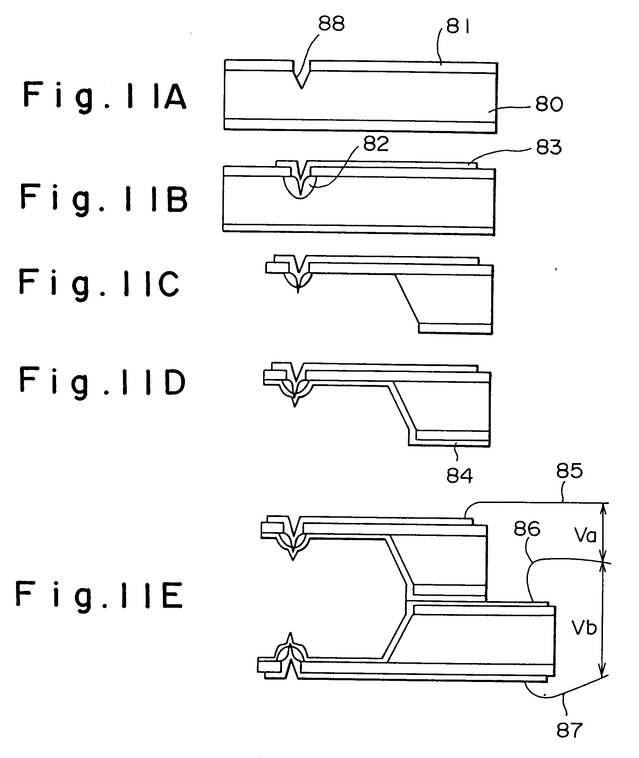

Embodiment 6, which is a first embodiment of the present invention, is next described in detail referring to Fig. 10 and Figs. 11A-11E.

Fig. 10 is a schematic, perspective view to show a micro gripper according to the first embodiment of the present invention.

This micro gripper has a support member 92, a pair of flexible plates 93 supported by the support member 92 at one end thereof and opposed to each other at a constant space between them, coil layers 91 each formed on an outer surface of each flexible plate 93, thermocouples 94 each formed in a portion for gripping a sample and at the distal end of each flexible plate 93, a power supply 95 electrically connected to the coil layers 91, metal films 83, 84 electrically connected to the two respective thermocouples, a detector 96 for measuring a thermoelectromotive force, and conductors 85, 86, 87 for electrically connecting the detector 96 to the metal films 83, 84.

The method for producing the micro gripper of the present embodiment is next described. Figs. 11A to 11E are schematic cross sections to illustrate production procedures of the micro gripper of the present embodiment.

First, a silicon nitride film 81 is formed in the thickness of 700 nm on an n-type silicon substrate 80 of the diameter of 7.6 cm (3 inches), the thickness of 250 µm, and the (100) orientation covered with a spontaneous oxide layer by the low pressure vapor phase growth method from raw materials of dichlorosilane and ammonium gas. Further, the silicon nitride film on the substrate is partially removed by the photolithography process and dry etching process. The shape of the removed portion is about 5 µm to about 10 µm square. The shape and size of the pattern can be arbitrarily determined. After that, this substrate is immersed in a silicon etchant such as the KOH solution or the TMAH solution to etch the exposed silicon portion in a quadrangular pyramid shape, thus forming a recess 88 (Fig. 11A).

After that, the sample is set in an electric oven to make a silicon dioxide film 82 grow in an exposed portion of the recess 88. As well known, a speed of growth of the silicon dioxide film is fast in a flat portion but slow in a corner portion. Thus, a cross section of the silicon dioxide film thus grown in the recess 88 becomes as shown in Fig. 11B, in which the thickness of the bottom part is extremely thin. Patterning of a metal film 83, for example of gold, platinum, nichrome, chromel, alumel, platinum-rhodium, or nickel, is performed on the top surface of the sample by the lift-off method to form a constituent part of the thermocouple and a thin-film member for drive (coil layer 91) at a time (Fig. 11B).

Then this sample is subjected to patterning in the shape of flexible plate in the silicon nitride film on the top surface of substrate and in the shape of support member on the back surface of substrate. Next, the sample is immersed in the TMAH solution in concentration of 20 to 25 wt% as heated to 80° to dissolve only unnecessary silicon portions (Fig. 11C).

Then the sample is immersed in the KOH solution in concentration of 40 wt% as heated to 85° for about 30 minutes to etch the entire silicon dioxide layer of the probe portion in a negligible thickness, thereby slightly exposing the metal film 83 at the probe top part where the thickness of the silicon dioxide layer is thinnest. After that, a metal film 84 of a different kind from the metal film 83 previously formed is formed on the back surface of substrate. The above process provides a finger consisting of the support member for supporting the flexible plate, the flexible plate projecting from the support member, the thin-film member for drive, and the probe provided with the pair of different metal films, that is, a thermocouple at the top part in the distal end region of the flexible plate.

Two such fingers are produced in the above manner. The two fingers thus produced have different lengths of support members, the smaller support member having the size of width 2 mm and length 4 mm while the larger one having the size of width 2 mm and length 8 mm.

The two fingers thus produced with different sizes of support members are bonded to each other with a conductive adhesive containing silver as a main ingredient on the side of the two support members, and conductors 85-87 for connecting the metal films 83, 84 with the detector in order to measure thermoelectromotive forces Va and Vb are bonded to the metal films 83 and 84. In the case of the present embodiment, the metal film 84 is a common electrode to the two thermocouples.

Next described is the operation of the micro gripper according to Embodiment 6.

Since the opening/closing operation of the flexible plates of this micro gripper is substantially the same as that of the micro gripper as disclosed in Japanese Laid-open Patent Application No. 5-253870 as described previously, the detailed description thereof is omitted, but it is briefly described in the following.

A magnetic field is applied to the micro gripper so that a direction of the magnetic field coincides with the longitudinal direction of the flexible plates 93. Then an electric current is supplied from the power supply 95 independently to the coil layers 91 each formed on the outside surface of flexible plate 93. Then each flexible plate 93 receives a Lorentz force depending upon the direction of electric current and the direction of magnetic field, whereby the opening/closing operation of micro gripper can be made. In this case, because the direction of an electric current applied to each coil layer 91 is selected independently of the other, the opening/closing operation of each flexible plate 93 can be performed independently.

Next described is a method for measuring the temperature of the gripped object by the micro gripper of Embodiment 6.

As described previously, the thermocouple generates different electromotive forces in the respective conductors depending upon the temperature of contact (Seebeck effect). Accordingly, the temperature of the gripped object can be measured by measuring by the detector 96 a thermoelectromotive force generated between the metal films 83 and 84 when the micro gripper grips the gripped object. Since the present embodiment includes two thermocouples 94 provided in the two respective flexible plates 93, temperature measurement can be carried out by the respective thermocouples independently of each other.

Measurement was conducted using the thus obtained micro gripper. While the produced micro gripper was gripping an egg of sea urchin in the diameter of about 100 µm, YAG laser light was irradiated onto the egg. It was confirmed that the temperature of the sample increased at the same time as the irradiation of laser light. It was thus checked that temperature measurement of a gripped substance, having never been realized heretofore, became possible. Although the present embodiment was so arranged that the thermocouples were provided each at the distal end of each of the two flexible plates in the micro gripper, it is noted that the temperature of sample can be measured as long as at least one thermocouple is provided.

Further, the present embodiment was so arranged that the sizes of the upper and lower support members were different from each other in order to measure the electromotive forces from the thermocouples, but they may be formed in a same size as long as the electromotive forces from the thermocouples can be measured.

Although the present embodiment utilized the Lorentz force by providing the coil layers in order to perform the opening/closing operation of the flexible plates, the opening/closing operation may be conducted using another method. For example, the opening/closing operation can be done for example in such a manner that the flexible plates are made of two types of materials with different thermal expansion coefficients and that the heat is applied to the flexible plates to effect thermal drive.

### Embodiment 7

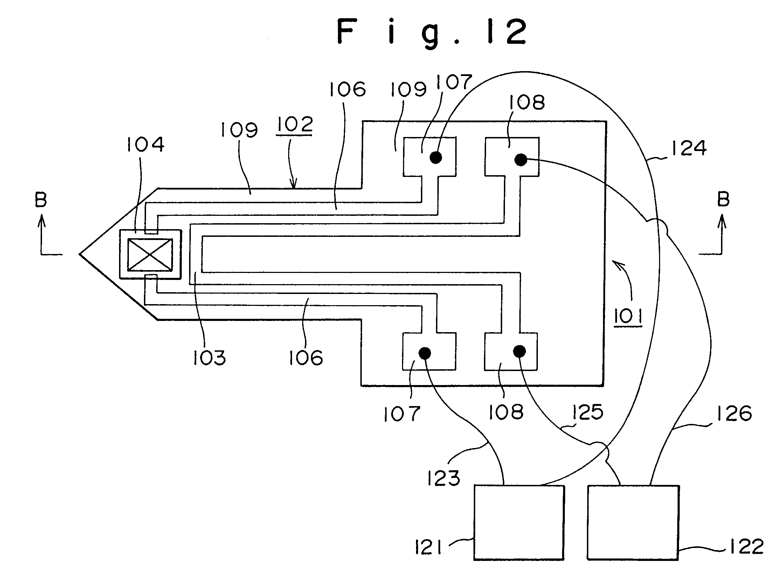

A micro gripper according to Embodiment 7, a second embodiment of the present invention, is next described referring to Figs. 12, 13, and 14A-14D.

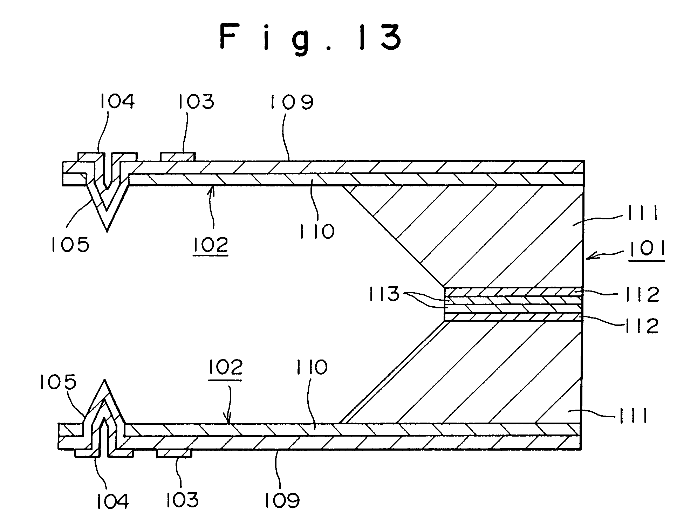

Fig. 12 is a schematic plan view of the micro gripper according to the second embodiment of the present invention. Fig. 13 is a schematic cross section along B-B line in Fig. 12.

This micro gripper is provided, as shown in Fig. 12 and Fig. 13, with a support member 101, a pair of fingers 102 supported by the support member 101 at one end thereof and opposed to each other at a predetermined space between them, coil layers 103 (thin-film members for drive) each formed on an outer surface of each finger 102 as opening/closing means for opening and closing the pair of fingers 102, and heating resistors 104 for heating at least part of a region where the pair of fingers 102 grip a gripped object.

In the present embodiment each finger 102 has a projection 105 as a region for gripping the gripped object and the each heat resistor 104 is formed in the portion of projection 105. The material for heat resistors 104 may be selected for example from high-resistance metal films of Ta, nichrome, nickel, etc. and inorganic materials such as tantalum pentoxide, etc. Each finger 102 is composed of a flexible plate and, more specifically, of double layers of silicon nitride films 109, 110. The support member 101 is composed of the silicon nitride films 109, 110, the silicon layer 111, and silicon nitride layers 112, 113. It should be, however, noted that the structure of each finger 102 and the support member 101 is not limited to the above structure.

Wiring patterns 106 electrically connected to the heat resistor 104 are formed at a space to the coil layer 103 on an outer surface of each finger. The wiring patterns 106 also extend on the support member 101 to be connected with electrode patterns 107 formed on the support member 101, for electric connection to the outside. Similarly, the coil layer 103 also extends on the support member 101 to be connected with electrode patterns 108 formed on the support member 101, for electric connection to the outside.

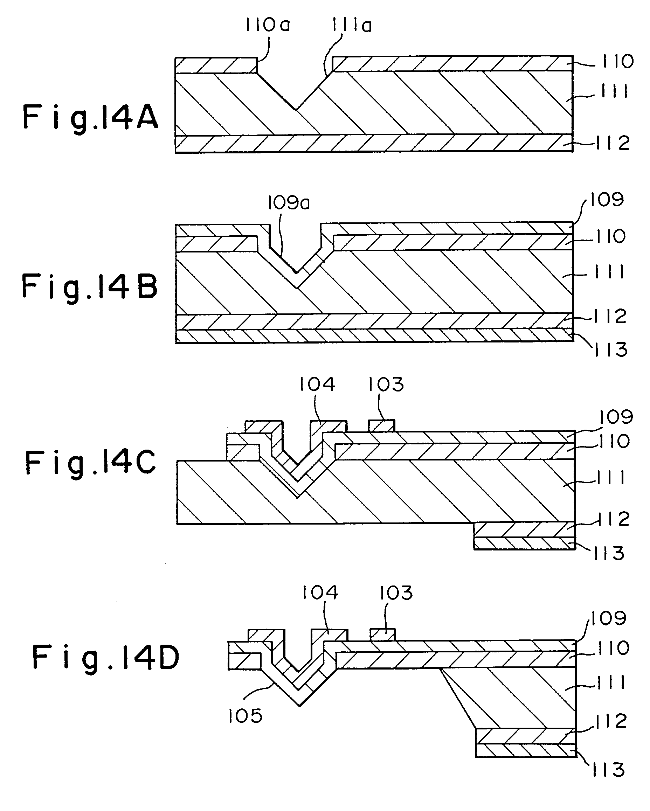

An example of a method for producing the micro gripper shown in Fig. 12 and Fig. 13 is next described referring to Figs. 14A to 14D. Figs. 14A to 14D are schematic cross sections to show an example of production steps of the micro gripper shown in Fig. 12 and Fig. 13. In Figs. 14A to 14D, elements corresponding to those in Fig. 12 are denoted by the same reference numerals.

First, silicon nitride films 110, 112 are formed in the thickness of 400 nm on either surface of an n-type silicon substrate 111 of the diameter of 7.6 cm (3 inches), the thickness of 250 µm, and the (100) orientation by the low pressure vapor phase growth method from raw materials of dichlorosilane and ammonium gas. Further, the silicon nitride film 110 on the top surface of substrate 111 is subjected to patterning by the photolithography process and dry etching process, whereby a square opening 110a is formed with a side of about 5 µm to 10 µm as exposing the surface of substrate 111 at a predetermined portion of the silicon nitride film 110 on the top surface of substrate 111. The pattern shape, size, and number of opening 110a can be arbitrarily determined. After that, this substrate is immersed in a silicon etchant such as the KOH solution or the TMAH solution to etch the portion of substrate 111 exposed through the opening 110a in a quadrangular pyramid shape with a mask of the silicon nitride films 110, 112, thereby forming a quadrangular pyramid trench 111a continuously connected to the opening 110a in the silicon nitride film 110 (Fig. 14A). Since the substrate 111 is of the (100) orientation, etching automatically stops at (111) facet of silicon as well known, thus making the surface of trench 111a tapered at an angle of 54.7°.

After that, silicon nitride films 109, 113 are formed in the thickness of 300 nm on the both sides of the substrate in the state shown in Fig. 14A by the low pressure vapor phase growth method from raw materials of dichlorosilane and ammonium gas (Fig. 14B).

Next, patterning of a film of a high-resistance metal material such as Ta, nichrome, nickel, etc. or an inorganic material such as tantalum pentoxide is conducted on the top surface of the substrate in the state shown in Fig. 14B by the lift-off method etc., whereby a heat resistor 104 is formed in a rectangular shape in and around the portion of trench 109a in the silicon nitride film 109. Further, patterning of a metal layer, for example of gold, aluminum, copper, etc., is conducted on the top surface of the silicon nitride film 109 by the lift-off method, whereby a coil layer 103, wiring patterns 106, and electrode patterns 107, 108 (Fig. 12) are formed. After that, the silicon nitride layers 109, 110, 112, 113 on the both sides of substrate 111 are subjected to patterning by the photolithography process and dry etching process so as to match with the desired shape of finger 102 and the desired shape of support member 101 (Fig. 14C).

Then the substrate in the state shown in Fig. 14C is immersed in the TMAH solution in concentration of 20 to 25 wt% and at 80 °C or the KOH solution in concentration of 40 wt% and at 85 °C, thereby dissolving only, unnecessary silicon portions exposed by the patterning. This completes a finger body in a cantilever state as shown in Fig. 14D.

Two such finger bodies shown in Fig. 14D are prepared and bonded to each other by an adhesive etc. between portions to become the support members 101. This completes the micro gripper shown in Fig. 12 and Fig. 13.

Next described is the operation of the micro gripper shown in Fig. 12 and Fig. 13.

For using the micro gripper, as shown in Fig. 12, conductor 123, 124 connects each electrode pattern 107 with a heating power supply 121 and conductor 125, 126 connects each electrode pattern 108 with a driving power supply 122. This micro gripper is placed in an external magnetic field.

Since the opening/closing operation of the fingers in the micro gripper is the same as in Embodiment 6, and thus, the description thereof is omitted herein.

In actual work, for example, the micro gripper is mounted on a commercially available manipulator that can be hydraulically driven in three dimensions, whereby a substance as a gripped object can be gripped on a microscope stage on which a permanent magnet for providing the external magnetic field is fixed.

When an electric current is supplied from the heating power supply 121 to the heat resistor 104, the heat resistor 104 generates Joule heat to heat the projection 105 as a region for gripping the gripped object. On this occasion, the heat resistors 104 of the respective fingers 102 may be simultaneously energized or only one of heat resistors 104 may be energized.

Thus, using the micro gripper shown in Fig. 12 and Fig. 13, the instant that the gripped object is gripped, the gripped object can be locally heated by the projection 105 heated by the heat resistor 104. Therefore, the micro gripper can realize thermal conduction analysis in a micro region for gripped objects such as fine mechanical components, and biochemical inspection and evaluation for gripped objects such as living samples.

For example, the micro gripper can be used to grip an egg of sea urchin in diameter of about 100 µm and to heat in a local region at the same time. When the temperature of such an egg was simultaneously measured by a temperature meter using infrared rays, it was recognized that the temperature of the egg was increased depending upon the magnitude of the electric current supplied to the heat resistor 104.

### Embodiment 8

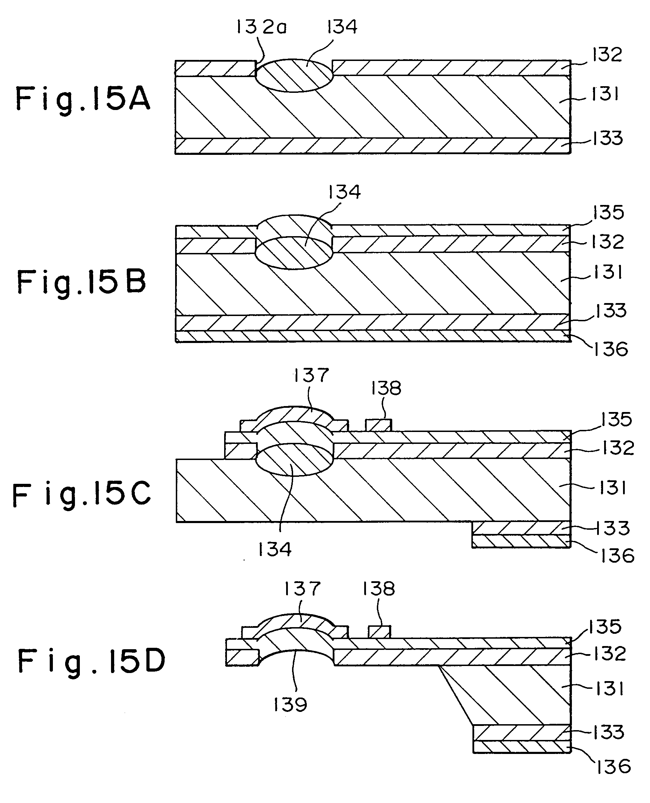

A micro gripper according to Embodiment 8, representing a third embodiment of the present invention, is next described referring to Figs. 15A to 15D.

Figs. 15A to 15D are schematic cross sections to show production steps of a finger body used for forming the micro gripper according to the present embodiment, and correspond to Figs. 14A to 14D, respectively.

Describing the production steps shown in Figs. 15A to 15D, silicon nitride films 132, 133 are first formed on the both surfaces of silicon substrate 131 by the low pressure vapor phase growth method from raw materials of dichlorosilane and ammonium gas. Further, the silicon nitride film 132 on the upper surface of substrate 131 is subjected to patterning by the photolithography process and dry etching process, whereby a circular opening 132a exposing the surface of substrate 131 is formed in a predetermined portion of the silicon nitride film 132 on the top surface of substrate 131. The pattern shape, size, and number of opening 132a can be arbitrarily determined. Then this substrate is set in an electric oven to be heated therein, whereby a silicon dioxide film 134 is grown by thermal oxidation in the exposed portion of substrate 131 through the opening 132a (Fig. 15A). As well known, the speed of growth of silicon dioxide film is fast in a flat portion but slow in a corner portion, and therefore, the cross section of silicon oxide film 134 thus grown becomes approximately oval as shown in Fig. 15A.

After that, the silicon nitride films 135, 136 are formed on the both surfaces of substrate in the state shown in Fig. 15A by the low pressure vapor phase growth method from raw materials of dichlorosilane and ammonium gas (Fig. 15B).

Next, patterning of a film, for example of a high-resistance metal material such as Ta, nichrome, nickel, etc. or an inorganic material such as tantalum pentoxide, is conducted by the lift-off method etc. on the top surface of substrate in the state shown in Fig. 15B, whereby a heating resistor 137 is formed in a circular shape above and around the silicon dioxide film 134. Further, patterning of a metal layer such as gold, aluminum, copper, etc. is conducted by the lift-off method on the top surface of silicon nitride layer 135, thereby forming a coil layer 138 corresponding to the coil layer 103 in Fig. 12, wiring patterns (not shown) corresponding to the wiring patterns 106 in Fig. 12, and electrode patterns (not shown) corresponding to the electrode patterns 107, 108 in Fig. 12. After that, patterning is conducted for the silicon nitride films 132, 133, 135, 136 on the both surfaces of substrate 131 by the photolithography process and dry etching process so as to match with the desired shape of finger and the desired shape of support member (Fig. 15C).

Then the substrate in the state shown in Fig. 15C is immersed in the strong alkali solution such as the KOH solution to dissolve unnecessary silicon portions and silicon dioxide film 134 exposed by the patterning. This completes a finger body in a cantilever state shown in Fig. 15D.

Then two such finger bodies shown in Fig. 15D are prepared and bonded to each other by an adhesive etc. between the portions to become the support members, similarly as in the bonding of the two finger bodies shown in Fig. 14D. This completes the micro gripper (not shown) according to the present embodiment.

In the micro gripper according to the present embodiment, each finger has a spherical, concave portion 139 (Fig. 15D) as a region for gripping the gripped object and a heat resistor 137 is formed in the portion of the concave portion 139.

Using the micro gripper according to this embodiment of the present invention, at the same time that the gripped object is gripped, it can be locally heated by the concave portion 139 heated by the heating resistor 137.

### Embodiment 9

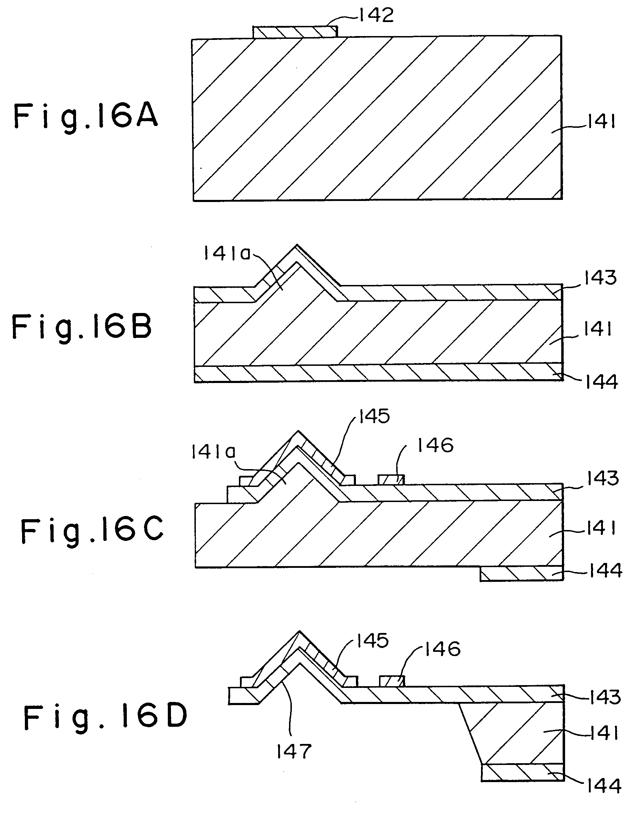

A micro gripper according to Embodiment 9 representing a fourth embodiment of the present invention is next described referring to Figs. 16A to 16D.

Figs. 16A to 16D are schematic cross sections to show production steps of a finger body used for constructing the micro gripper according to the present embodiment, and correspond to Figs. 14A to 14D, respectively.

Describing the production steps shown in Figs. 16A to 16D, a circular mask 142 is first formed at a predetermined portion on the top surface of silicon substrate 141 (Fig. 16A). The pattern shape, size, and number of mask 142 can be arbitrarily determined.

After that, this substrate is immersed in a hydrofluoric acid solution to isotropically etch silicon, thereby shaping the silicon substrate 141 in a plate form having a conic-shape projection 141a on the top surface thereof. This etching removes the mask 142 from the silicon substrate 141. Silicon nitride layers 143, 144 are formed on the both surfaces of the silicon substrate 141 in this state by the low pressure vapor phase growth method from raw materials of dichlorosilane and ammonium gas (Fig. 16B).

Next, patterning of a film, for example of a high-resistance metal material such as Ta, nichrome, nickel, etc. or an inorganic material such as tantalum pentoxide, is conducted by the lift-off method on the top surface of substrate in the state shown in Fig. 16B, whereby a heating resistor 145 is formed in a circular shape above and around the projection 141a. Further, patterning of a metal film such as gold, aluminum, copper, etc. is conducted by the lift-off method on the top surface of silicon nitride film 143, whereby a coil layer 146 corresponding to the coil layer 103 in Fig. 12, wiring patterns (not shown) corresponding to the wiring patterns 106 in Fig. 12, and electrode patterns (not shown) corresponding to the electrode patterns 107, 108 in Fig. 12 are formed. After that, patterning is done for the silicon nitride layers 143, 144 on the both surfaces of substrate 141 by the photolithography process and dry etching process so as to match with the desired shape of finger and the desired shape of support member (Fig. 16C).

Then the substrate in the state shown in Fig. 16C is immersed in the TMAH solution or the KOH solution to dissolve unnecessary silicon portions exposed by the patterning. This completes a finger body in a cantilever state shown in Fig. 16D.

Then two such finger bodies shown in Fig. 16D are prepared and bonded to each other by an adhesive etc. between the portions to become the support members, similarly as the bonding between the two finger bodies shown in Fig. 14D. This completes the micro gripper (not shown) according to the present embodiment.

In the micro gripper according to the present embodiment, each finger has a conic-shaped, concave portion 147 (Fig. 16D) as a region for gripping the gripped object, and a heating resistor 145 is formed in the portion of the concave portion 147.

Also using the micro gripper according to the present embodiment, at the same time that the gripped object is gripped, the gripped object can be locally heated by the concave portion 147 heated by the heat resistor 145.

### Embodiment 10

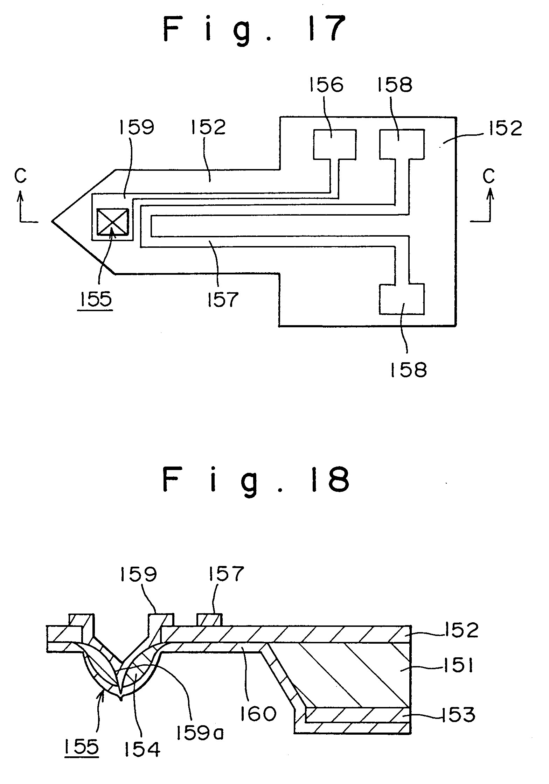

A micro gripper according to Embodiment 10, representing a fifth embodiment of the present invention, is next described referring to Figs. 17, 18, 19A and 19B.

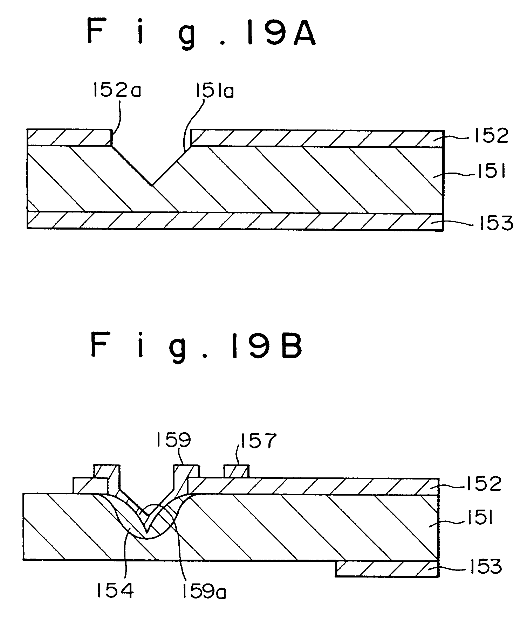

Fig. 17 is a schematic plan view of a finger body used for constructing the micro gripper according to the present embodiment. Fig. 18 is a schematic cross section along C-C line in Fig. 17. Figs. 19A and 19B are schematic cross sections to show an example of production steps of the finger body shown in Fig. 17 and Fig. 18.

An example of a method for producing the finger body is described referring to Figs. 17, 18, 19A, and 19B.

First, silicon nitride films 152, 153 are formed on the both surfaces of an n-type silicon substrate 151 of the (100) orientation by the low pressure vapor phase growth method from raw materials of dichlorosilane and ammonium gas. Further, patterning is done by the photolithography process and dry etching process for the silicon nitride film 152 on the upper surface of substrate 151, whereby a square opening 152a exposing the surface of substrate 151 is formed in a predetermined portion of silicon nitride film 152 on the upper surface of substrate 151. The pattern shape, size, and number of opening 152a can be arbitrarily determined. After that, this substrate is immersed in a silicon etchant such as the KOH solution or the TMAH solution to etch the exposed portion of substrate 151 through the opening 152a in a quadrangular pyramid shape, thereby forming a quadrangular pyramid trench 151a continuous to the opening 152a in the silicon nitride film 152 (Fig. 19A).

After that, the substrate in the state shown in Fig. 19A is set in an electric oven to be heated, whereby a silicon dioxide film 154 is grown by thermal oxidation in the exposed portion of trench 151a on the substrate 151. As well known, the speed of growth of silicon dioxide film is fast in a flat portion but slow in a corner portion. Thus, a cross section of the silicon dioxide film 154 grown in the portion of trench 151a becomes as shown in Fig. 19B, where the thickness of the bottom portion is extremely thinner than the other portions. After that, patterning of a metal film such as gold, platinum, nichrome, chrome, platinum-rhodium, nickel, etc. is conducted by a well-known procedure on the top surface of the substrate, thereby forming a constituent portion 159 of thermocouple 155 (Fig. 18), an electrode pattern 156 for thermocouple, a coil layer 157 corresponding to the coil layer 103 in Fig. 12, and electrode patterns 158 (Fig. 17) corresponding to the electrode patterns 108 in Fig. 12. A projection 159a (a portion of the constituent portion 159) formed in the portion of trench in the silicon dioxide layer 154 by the patterning of metal film becomes a junction portion between two different materials in the thermocouple 155, as will be apparent from the following description. Next, patterning is done by the photolithography process and dry etching process for the silicon nitride films 152, 153 on the both surfaces of substrate 151 so as to match with the desired shape of finger and the desired shape of support member (Fig. 19B).

Then the substrate is immersed in the TMAH solution to dissolve only unnecessary silicon portions exposed by the patterning. Further, this substrate is immersed in the KOH solution (this solution etches the silicon dioxide film at low speed) to isotropically etch a small amount of silicon dioxide film 154, thereby making the projection 159a slightly projecting from the top portion (corresponding to the thinnest portion before etching) of silicon dioxide film 154 after etched. Then a metal film 160 of a kind different from the previously formed metal film (namely; different from the material for projection 159a) is formed on the back surface of the substrate. This completes a finger body shown in Fig. 17 and Fig. 18.

In the present embodiment, the finger body shown in Fig. 17 and Fig. 18 is bonded to another finger body shown in Fig. 14D, Fig. 15D, or Fig. 16D by an adhesive etc. between portions to become support members, similarly as in the bonding of two finger bodies shown in Fig. 14D. This completes the micro gripper (not shown) according to the present embodiment.

In the micro gripper according to the present embodiment, a thermocouple 155 is provided in a portion not heated by the heating resistor and in a region where the paired fingers grip a gripped object. In using the micro gripper, an electromotive force appearing between the electrode pattern 156 and the metal film 160 is supplied as a temperature detection signal to a detector (not shown).

According to the present embodiment, at the same time that the gripped object is gripped, the gripped object can be locally heated by the region heated by the heating resistor. In addition, the temperature of the gripped object can be measured. Therefore, the thermal conduction analysis etc. of the gripped object can be further accurately performed, and a local region of the gripped object can be kept at a desired temperature by controlling an amount of electric current (consequently, an amount of heat of the heating resistor) to the heat resistor depending upon a measured temperature.

### Embodiment 11

A micro gripper according to Embodiment 11, representing a sixth embodiment of the present invention, is next described referring to Figs. 20, 21, and 22A to 22C.

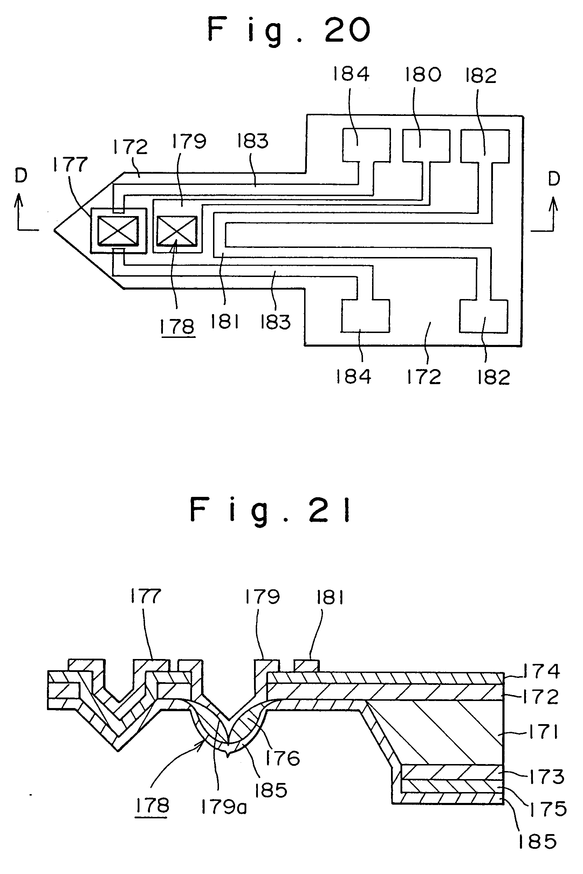

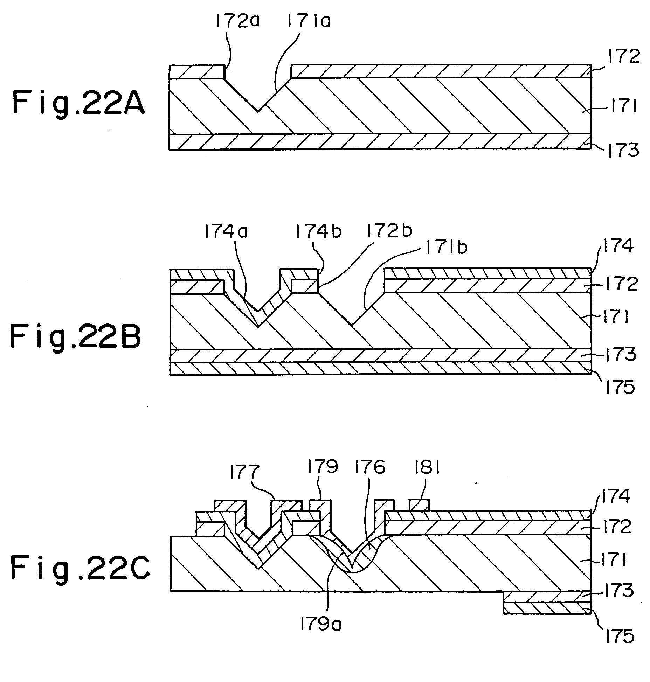

Fig. 20 is a schematic plan view of a finger body used for constituting the micro gripper according to the present embodiment. Fig. 21 is a schematic cross section along D-D line in Fig. 20. Figs. 22A to 22C are schematic cross sections to show an example of production steps of the finger body shown in Fig. 20 and Fig. 21.

An example of a method for producing this finger body is described referring to Figs. 20, 21, and 22A to 22C.

First, silicon nitride films 172, 173 are formed on the both surfaces of an n-type silicon substrate 171 of the (100) orientation by the low pressure vapor phase growth method from raw materials of dichlorosilane and ammonium gas. Further, the silicon nitride film 172 on the top surface of substrate 171 is subjected to patterning by the photolithography process and dry etching process, whereby a square opening 172a exposing the surface of substrate 171 is formed in a predetermined portion of the silicon nitride film 172 on the top surface of substrate 171. The pattern shape, size, and number of opening 172a can be arbitrarily determined. After that, this substrate is immersed in a silicon etchant such as the KOH solution or the TMAH solution to etch the exposed portion of substrate 171 through the opening 172a in a quadrangular pyramid shape with a mask of the silicon nitride films 172, 173, thereby forming a quadrangular pyramid trench 171a continuous to the opening 172a in the silicon nitride film 172 (Fig. 22A).

After that, silicon nitride films 174, 175 are formed on the both surfaces of substrate in the state shown in Fig. 22A by the low pressure vapor phase growth method from raw materials of dichlorosilane and ammonium gas. Next,patterning by the photolithography process and dry etching process is conducted for the silicon nitride films 172, 174 on the upper surface of substrate 171, thereby forming square openings 172b, 174b exposing the surface of substrate 171 in predetermined portions of the silicon nitride films 172, 174 on the upper surface of substrate 171. The pattern shape, size, and number of openings 172b, 174b can be arbitrarily determined. After that, this substrate is immersed in a silicon etchant such as the KOH solution or the TMAH solution to etch the exposed portion of substrate 171 through the openings 172b, 174b in a quadrangular pyramid shape with a mask of the silicon nitride films 174, 175, thereby forming a quadrangular pyramid trench 171b continuous to the openings 172b, 174b (Fig. 22B).

Then the substrate in the state shown in Fig. 22B is set in an electric oven to be heated therein, so that a silicon dioxide film 176 is grown by thermal oxidation in the exposed portion of trench 171b in the substrate 171. As well known, the speed of growth of silicon dioxide film is fast in a flat portion but slow in a corner portion. Thus, a cross section of the silicon dioxide film 176 grown in the portion of trench 171b becomes as shown in Fig. 22C, in which the thickness of the bottom portion is much thinner than the other portions. Next, patterning of a film, for example a high-resistance metal material such as Ta, nichrome, nickel, etc. or an inorganic material such as tantalum pentoxide, is conducted by the lift-off method etc. on the top surface of the substrate, whereby a rectangular heating resistor 177 is formed in and around the portion of trench 174a in the silicon nitride film 174. Further, patterning of a metal film such as gold, platinum, nichrome, chrome, platinum-rhodium, nickel, etc. is performed by a well-known method such as the lift-off method on the top surface of the substrate, thereby forming a constituent portion 179 of a thermocouple 178 (Fig. 21), an electrode pattern 180 for thermocouple, a coil layer 181 corresponding to the coil layer 103 in Fig. 12, electrode patterns 182 corresponding to the electrode patterns 108 in Fig. 12, wiring patterns 183 corresponding to the wiring patterns 106 in Fig. 12, and electrode patterns 184 (Fig. 20) corresponding to the electrode patterns 107 in Fig. 12. The projection 179a (a part of the constituent portion 179), formed in the portion of trench in the silicon dioxide film 176 by the patterning of metal film, becomes a junction portion between the different materials in the thermocouple 178, as will be apparent from the following description. Next, the silicon nitride films 172-175 on the both surfaces of substrate 171 are subjected to patterning by the photolithography process and dry etching process so as to match with the desired shape of finger and the desired shape of support member (Fig. 22C).

Then this substrate is immersed in the TMAH solution to dissolve only unnecessary silicon portions exposed by the patterning. Further, this substrate is immersed in the KOH solution (which etches the silicon dioxide film at low speed) to isotropically etch a very small amount of silicon dioxide film 176, thereby forming the projection 179a slightly projecting from the top part (corresponding to the thinnest portion before etching) of the silicon dioxide film 176 after etched. Next, a metal film 185 of a kind different from the previously formed metal film (i.e., different from the material of projection 179a) is formed on the back surface of the substrate. This completes a finger body shown in Fig. 21 and Figs. 22A to 22C.

Then two finger bodies shown in Fig. 20 and Fig. 21 are prepared and bonded to each other by an adhesive etc. between portions to become the support members. This completes the micro gripper (not shown) according to the present embodiment.

In the micro gripper according to the present embodiment, the thermocouple 178 is provided in a portion not heated by the heat resistor and in the region where the same fingers grip a gripped object. For using this micro gripper, an electromotive force generated between the electrode pattern 180 and the metal film 185 is supplied as a temperature detection signal to a detector not shown.

According to the present embodiment, at the same time that the gripped object is gripped, the gripped object can be locally heated by the region heated by the heating resistor. In addition, the temperature of the gripped object can also be measured. Thus, the thermal conduction analysis etc. of the gripped object can be further accurately carried out, and a local portion of the gripped object can be kept at a desired temperature by controlling an amount of supply current to the heating resistor (thus, an amount of heat of the heating resistor), depending upon a measured temperature.

Since the micro gripper according to the present embodiment is so arranged that the heating resistor 177 and thermocouple 178 are provided in a same finger, the distance between the heating resistor 177 and the thermocouple 178 can be kept constant at a known value, which is thus further convenient in performing the thermal conduction analysis etc.

Various embodiments of the present invention were described above in detail, but it should be noted that the present invention is by no means limited to these embodiments.

For example, the invention allows the silicon nitride film 14-3 to be formed as being perfectly flat without forming the concave portion 147 in the silicon nitride film 143 in the finger body of Fig. 16D. However, when the fingers have the convex portions or concave portions as a region for gripping the gripped object and when the heating resistors heat the convex portions or concave portions, a heating portion to the gripped object can be readily specified, which is thus preferably.

In the present invention, the micro gripper can be constructed in any combination between the finger bodies as described. Also, there are no restrictions on the number of heating resistors and the number of thermocouples. The heating resistor may be provided on each of the pair of fingers or only on one of them. The heating resistor may be provided over the entire area of finger for gripping the gripped object, or only in a part of the region.

The above-described embodiments utilized the Lorentz force by the coil layer provided in the each finger for performing the opening/closing operation of fingers, but the opening/closing operation of fingers may be performed by another method. For example, the opening/closing operation can be effected by thermal drive in such a manner that the flexible plate forming the finger is made of two types of materials with different thermal expansion coefficients and that heat is applied to the flexible plate. In each embodiment as described above, the thermal drive is possible utilizing a difference in thermal expansion coefficient between the coil layer (thin-film member for drive) and the silicon nitride film as a finger material without an extra modification.

Further, the present invention can also be applied to electrostatic micro grippers, micro grippers using a piezoelectric device, etc.

If each of two fingers is provided with a metal plate and if an electric capacity (capacitance) is detected between the metal plates, a gripping state etc. can be detected by a change in the capacitance. Thus, it can be accurately judged whether or not the gripped object is gripped.

A micro gripper of the present invention comprises two fingers and a support member for supporting the two fingers as opposed to each other at an interval, wherein each of the two fingers is provided with a metal plate.

Further, if each finger is provided with a resistor instead of the metal plate and if a resistance of the resistor changing depending upon deflection of finger is detected, the gripped state etc. can also be detected from a change in the resistance. Thus, another micro gripper of the present invention comprises two fingers and a support member for supporting the two fingers as opposed to each other at an interval, wherein the two fingers are two flexible fingers and at least one of the two flexible fingers is provided with a resistor.

Preferably, the at least one of the two fingers is provided with a concave or convex capture holding portion for capturing the gripped object.

A micro gripper drive apparatus of the present invention comprises the micro gripper, moving means for moving the micro gripper, opening/closing means for opening and closing the two fingers, and detecting means for detecting the capacitance between the metal plates.

Another micro gripper drive apparatus of the present invention comprises the micro gripper, moving means for moving the micro gripper, opening/closing means for opening and closing the two fingers, and detecting means for detecting the resistance of the resistor.

The micro gripper drive apparatus of the present invention may comprise drive signal control means for changing a drive signal of the micro gripper, depending upon the capacitance between the metal plates.

The micro gripper drive apparatus of the present invention may comprise drive signal control means for changing the drive signal of the micro gripper, depending upon the resistance of the resistor.

Incidentally, opening/closing of flexible finger can be effected when it is formed of thin films in at least two layers different in thermal expansion coefficient and when heat is applied to the flexible finger.

Thus, another micro gripper of the present invention comprises flexible fingers each consisting of thin films in at least two layers different in thermal expansion coefficient, and a support member for supporting the flexible fingers.

Still another micro gripper of the present invention comprises two flexible fingers, a support member for supporting the two flexible fingers as opposed to each other at an interval, and opening/closing drive means for opening and closing the flexible fingers, wherein a probe of a conductor is provided at the distal end of flexible finger.

The probe is preferably constructed of an insulator and a conductor exposed only at the top part of the insulator. In this case, the insulator is preferably silicon nitride and the conductor is preferably a metal.

The opening/closing drive means is preferably a micro coil formed in each of the two flexible fingers.

Alternatively, the opening/closing drive means preferably consists of at least two metal layers provided in each of the two flexible fingers and the at least two metal layers preferably have different thermal expansion coefficients.

Another micro gripper comprises a support member, a pair of flexible plates supported by the support member at one end thereof, and opening/closing means for opening and closing the pair of flexible plates, wherein a thermocouple is provided in a region for gripping the gripped object, of at least one of the pair of flexible plates.

When an electric current flows through the coil layer in the each flexible plate under the magnetic field, the coil layer is subject to a Lorentz force because of the magnetic field, thereby deforming the flexible plate. Where a thermocouple is provided in the region at the distal end of the flexible plate, the temperature can be measured at the same time that the gripped object is gripped.

As is well known, the thermocouple is constructed by bonding two different types of conductors (mainly metals) at portions thereof, and different electromotive forces appear in the respective conductors depending upon the temperature at the contact (the Seebeck effect).

Another micro gripper comprises a support member, a pair of fingers supported by the support member at one end thereof, and opening/closing means for opening and closing the pair of fingers, which is provided with a heat resistor for heating at least a part of a region for gripping the gripped object, of at least one of the pair of fingers.

The thermocouple may be provided at a portion that is not heated by the heat resistor and that is at least a part of the region for gripping the gripped object, of the at least one of the pair of fingers.

The heat resistor and thermocouple are preferably set on a same finger.

The region where the fingers grip the gripped object may have a convex portion or a concave portion, and the heat resistor may heat the convex portion or the concave portion.

Further, the region where the fingers grip the gripped object may have a flat portion, and the heat resistor may heat the flat portion.

## Claims

1. A micro gripper device comprising:
a support member (5);
two mutually opposed flexible fingers (4) supported by said support member (5), said flexible fingers having gripping ends for gripping an object therebetween; and
opening/closing drive means (2) for gripping operation of said two fingers,
characterized by:
a thermal mechanism (94, 104, 137, 145, 155, 177, 178) provided on at least one of said gripping ends and for heating said object gripped by said gripping ends or measuring a temperature of said object gripped by said gripping ends; and
an electrode (83, 107, 156, 180, 184) provided on at least one of said two fingers (4) and connected to said thermal mechanism, said electrode being provided for applying a voltage to said thermal mechanism or conducting current from said thermal mechanism.

2. A micro gripping device according to Claim 1, wherein said thermal mechanism is a thermocouple (94, 155, 178) placed on said at least one of said gripping ends and said thermocouple contacts said object when said object is gripped by said fingers.

3. A micro gripping device according to Claim 1, wherein said thermal mechanism is a heat-generator (104, 137, 145, 177) for generating heat and for applying the generated heat to said object gripped by said fingers.

4. A micro gripping device according to any one of the preceding claims, wherein said opening/closing drive means comprises a micro coil (91, 103) formed in at least one of said two fingers so that at least one of said fingers is moved by applying a current to said micro coil when said micro coil is in a magnetic field.

5. A micro gripping device according to any one of Claims 1, 2 or 3, wherein said opening/closing drive means has thin film attached to said finger, of at least one layer with different thermal expansion coefficients from the material of said finger.

6. Micro gripping apparatus comprising:
a micro gripping device according to any one of the preceding claims; and
moving means (31) for moving said support member (5).

## Patentansprüche

1. Eine Mikrogreifeinrichtung, umfassend:
ein Halteelement (5);
zwei einander gegenüberliegende flexible Finger (4), die durch das Halteelement (5) gehalten werden, wobei die flexiblen Finger Greifenden aufweisen, um dazwischen ein Objekt zu halten; und
Öffnungs-/Schließantriebseinrichtungen (2) zum Greifbetrieb der zwei Finger,
**gekennzeichnet durch,**
einen thermischen Mechanismus (92, 104, 137, 145, 155, 177, 178), der an mindestens einem der Greifenden vorgesehen ist und zum Erwärmen des durch die Greifenden gehaltenen Objektes oder zum Messen einer Temperatur des durch die Greifenden gehaltenen Objekts; und
eine Elektrode (83, 107, 156, 180, 184), die an mindestens einem der zwei Finger (4) vorgesehen ist und mit dem thermischen Mechanismus verbunden ist, wobei die Elektrode zum Anlegen einer Spannung an den thermischen Mechanismus oder zum Leiten eines Stromes von dem thermischen Mechanismus vorgesehen ist.

2. Eine Mikrogreifeinrichtung nach Anspruch 1,
**dadurch gekennzeichnet, daß**
der thermische Mechanismus ein Wärmekoppler (94, 155, 178) ist, der an mindestens einer Seite der Greifenden angeordnet ist, und der Wärmekoppler berührt das Objekt berührt, wenn das Objekt von den Fingern gehalten wird.

3. Eine Mikrogreifeinrichtung nach Anspruch 1,
**dadurch gekennzeichnet, daß**
der thermische Mechanismus ein Wärmegenerator (104, 137, 145, 177) ist, zum Erzeugen von Wärme und zum Anlegen der erzeugten Wärme an das von den Fingern gehaltene Objekt.

4. Eine Mikrogreifeinrichtung nach einem der vorangegangenen Ansprüche,
**dadurch gekennzeichnet, daß**
die Öffnungs-/Schließantriebseinrichtung eine Mikrospule (91, 103) umfaßt, die in mindestens einem der zwei Finger ausgebildet ist, so daß mindestens einer der Finger durch Anlegen eines Stromes an die Mikrospule bewegt wird, wenn die Mikrospule in einem magnetischen Feld ist.

5. Eine Mikrogreifvorrichtung nach einem der Ansprüche 1, 2 oder 3,
**dadurch gekennzeichnet, daß**
die Öffnungs/Schließantriebsvorrichtung einen dünnen Film an dem Finger befestigt aufweist, wobei mindestens eine Schicht einen von dem Material des Fingers verschiedenen thermischen Expansionskoeffizienten aufweist.

6. Mikrogreifvorrichtung, umfassend:
eine Mikrogreifeinrichtung nach einem der vorangegangenen Ansprüche; und
Bewegungseinrichtungen (31) zum Bewegen des Haltelementes (5).

## Revendications

1. Dispositif à micro pince comportant:
un élément de support (5);
deux doigts flexibles (4) opposés l'un à l'autre, soutenus par ledit élément de support (5), lesdits doigts flexibles présentant des extrémités de pinçage pour pincer un objet entre eux;
un moyen (2) d'entraînement d'ouverture/fermeture, pour l'action de pinçage desdits deux doigts,
caractérisé par:
un mécanisme thermique (94, 104, 137, 145, 155, 177, 178) prévu sur au moins l'une desdites extrémités de pinçage et pour chauffer ledit objet pincé par lesdites extrémités de pinçage ou pour mesurer une température dudit objet pincé par lesdites extrémités de pinçage; et
une électrode (83, 107, 156, 180, 184) prévue sur au moins l'un desdits deux doigts (4) et reliée audit mécanisme thermique, ladite électrode étant prévue pour appliquer une tension sur ledit mécanisme thermique ou pour conduire un courant provenant dudit mécanisme thermique.

2. Dispositif à micro pince selon la revendication 1, dans lequel ledit mécanisme thermique est un thermocouple (94, 155, 178) placé au moins sur ladite des extrémités de pinçage, et ledit thermocouple vient en contact avec ledit objet lorsque ledit objet est pincé par lesdits doigts.

3. Dispositif à micro pince selon la revendication 1, dans lequel ledit mécanisme thermique est un générateur de chaleur (104, 137, 145, 177) pour produire de la chaleur et pour appliquer la chaleur produite sur ledit objet pincé par lesdits doigts.

4. Dispositif à micro pince selon l'une quelconque des revendications précédentes, dans lequel ledit moyen d'entraînement d'ouverture/fermeture comporte un micro bobinage (91, 103) formé dans au moins l'un desdits deux doigts, de telle sorte qu'au moins l'un desdits doigts est déplacé par l'application d'un courant dans ledit micro bobinage lorsque ledit micro bobinage se trouve dans un champ magnétique.

5. Dispositif à micro pince selon l'une quelconque des revendications 1, 2 ou 3, dans lequel ledit moyen d'entraînement d'ouverture/fermeture présente un film mince fixé audit doigt, constitué d'au moins une couche avec des coefficients de dilatation thermique différents de celui du matériau dudit doigt.

6. Appareil à micro pince comportant:
un dispositif à micro pince selon l'une quelconque des revendications précédentes; et
un moyen de déplacement (31) pour déplacer ledit élément de support (5).
